# EUROPEAN PATENT APPLICATION

(11) **EP 3 883 355 A1**
(43) Date of publication of application: **22.09.2021**
(21) Application number: 20163289.0
(22) Date of filing: 16.03.2020
(51) Int. Cl.: H05K 7/20

(54) **A SUBSEA INSTALLATION**

(71) Applicant: ABB Schweiz AG, 5400 Baden (CH)
(72) Inventor: Missing, Kim, 65320 Vaasa (FI); Norolampi, Mika, 65320 Vaasa (FI)
(74) Representative: Kolster Oy Ab

(57) **Abstract**

The subsea installation comprises an enclosure filled with a dielectric fluid, an electric component positioned within the enclosure, and a cooling arrangement (100) for intensifying the cooling of the dielectric fluid within the enclosure. The cooling arrangement comprises an impeller (110) fitted within the enclosure and a motor (130) fitted outside the enclosure, the impeller being connected to the motor via a contactless coupling (120, 140) based on magnets positioned on opposite sides of a wall (23) of the enclosure, whereby the wall of the enclosure remains unbroken.

## Description

### FIELD

The invention relates to a subsea installation.

### BACKGROUND

Subsea installations are used e.g. in modern oil and gas production facilities in which the collection, separation, boosting and transport of the oil and the gas takes place on the seabed. These processes require large amounts of electric power that must be transferred from a remote location to the subsea installation. A high need of electric power may require a high voltage in the transfer of electric power in order to minimize power losses.

A subsea installation may comprise one or several electrical apparatuses and other apparatuses used under water e.g. on the bottom ground of a sea. The subsea installation may comprise one or more electrical components e.g. power transformers, drives, electric motors, switchgears enclosed in one or more enclosures. The drives may be variable speed drives VSD based on frequency converters. The subsea installation may also require a power grid as well as control, monitoring and process systems.

An electric component e.g. a transformer or a drive in a subsea installation has an operation life of 30 years without service, as an industry standard. This operation life without service might even be further prolonged e.g. to 50 years in the future. This is achievable in subsea installations in which the passive cooling to the sea water is used i.e. there are no mechanical moving parts within the enclosure of the subsea installation.

The introduction of forced cooling into the subsea installation increases the cooling capability. A motor driving an impeller circulating the dielectric fluid in the subsea installation will, however, limit the life of the subsea installation without service. The motor will need service during a life span in the range of 30 to 50 years.

A subsea installation comprising an electric component in an enclosure has a requirement of a double barrier towards sea water, including a tightness testable intermediate barrier. A steel wall or welded construction is considered a double barrier.

There is thus a need to be able to provide the subsea installation with a forced cooling by an impeller and a motor without limiting the operation life of the electric components in the subsea installation.

### SUMMARY

An object of the invention is to provide an improved subsea installation.

The subsea installation according to the invention is defined in claim 1.

The subsea installation comprises
an enclosure filled with a dielectric fluid,
an electric component being positioned within the enclosure,
a cooling arrangement for intensifying the cooling of the dielectric fluid within the enclosure.

The subsea installation is characterized in that
the cooling arrangement comprises an impeller fitted within the enclosure and a motor fitted outside the enclosure, the impeller being connected to the motor via a contactless coupling based on magnets positioned on opposite sides of a wall of the enclosure, whereby the wall of the enclosure remains unbroken.

The fact that the motor is positioned outside the enclosure makes it possible to service the motor without the need to be able to open the enclosure containing the electric component.

The motor could be positioned in a separate casing attached to an outer surface of the enclosure. The casing with the motor could then be arranged as a changeable unit on the outer surface of the enclosure.

The use of a contactless coupling between the impeller and the motor results in that the walls of the enclosure remains unbroken. Problems relating to sealings in shafts passing through a wall of the enclosure are thus eliminated in this arrangement.

### DRAWINGS

In the following the invention will be described in greater detail by means of preferred embodiments with reference to the attached drawings, in which
Figure 1 shows a cross-sectional side view of a subsea installation according to the invention,
Figure 2 shows a cross-sectional side view of a cooling arrangement of the subsea installation of figure 1,
Figure 3 shows a cross-section of a magnet structure.

### DETAILED DESCRIPTION

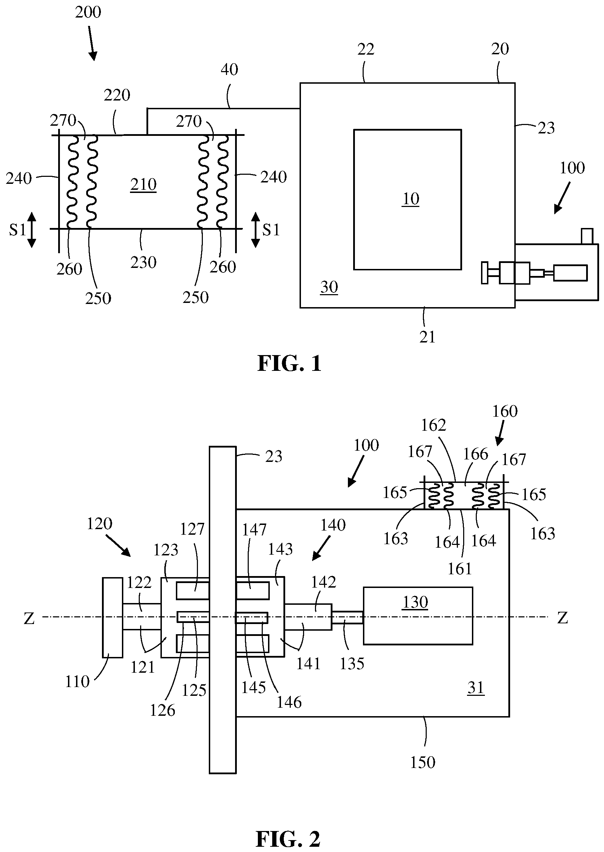

Figure 1 shows a side view of a subsea installation according to the invention.

The subsea installation may comprise an electric component 10 positioned within an enclosure 20. The electric component 10 may be a transformer and/or a variable speed drive VSD for an electric drive motor. The enclosure 20 may be a tank 20. The tank 20 may be formed of a bottom wall 21, a top wall 22, and at least one side wall 23. The walls 21, 22, 23 may form a closed compartment. A horizontal cross-section of the tank 20 may have the form of a rectangle or a circle or an ellipse or a polygonal or any combination of these. The tank 20 may be filled with a dielectric fluid 30. The electric drive motor may be positioned outside the enclosure 20. The electric drive motor may e.g. drive a compressor or a pump.

A first pressure compensator 200 may be arranged in connection with the tank 20. The first pressure compensator 200 may be connected via a duct 40 to the tank 20. The dielectric fluid 30 in the tank 20 may thus flow in the duct 40 from the tank 20 to the first pressure compensator 200 and vice a versa.

The first pressure compensator 200 may comprise a stationary top plate 220 and a movable bottom plate 230. The bottom plate 230 may be movably supported on guide members 240 being attached to the top plate 220. The bottom plate 230 may thus move S1 along the guide members 240.

The first pressure compensator 200 may further comprise a first bellows member 250 extending between the stationary top plate 220 and the movable bottom plate 230. A first bellows chamber 210 is formed by the top plate 220, the bottom plate 230 and the first bellows member 250. The first bellows member 250 forms a flexible member between the top plate 220 and the bottom plate 230. The first bellows member 250 expands and/or contracts when the bottom plate 230 moves in either direction S1 i.e. away from the top plate 220 or towards the top plate 220. The first bellows member 250 may have a substantially cylindrical form.

The first pressure compensator 200 may further comprise a second bellows member 260 extending between the stationary top plate 220 and the movable bottom plate 230. The first bellows member 250 is enclosed by the second bellows member 260. A second bellows chamber 270 is formed between the first bellows member 250 and the second bellows member 260. The second bellows member 260 separates the first bellows member 250 from the surrounding sea water. The second bellows chamber 270 may be filled with an intermediate medium. The second bellows member 260 may have a substantially cylindrical form.

The first bellows chamber 210 may be connected to the tank 20 via a pipe system 40. The first pressure compensator 200 will thus compensate for the volume variations of the dielectric fluid 30 in the tank 20. When the volume of the dielectric fluid 30 in the tank 20 increases, then a portion of the dielectric fluid 30 will flow from the tank 20 via the pipe system 40 to the first bellows chamber 210. This will cause the bottom plate 230 to move further away from the top plate 220 so that the volume of the first bellows chamber 210 increases. When the volume of the dielectric fluid 30 in the tank 20 decreases, then a portion of the dielectric fluid 30 will flow from the first bellows chamber 210 via the pipe system 40 to the tank 20. This will cause the bottom plate 230 to move towards the top plate 220 so that the volume of the first bellows chamber 210 decreases. The first pressure compensator 200 will thus compensate for the volume variations in the tank 20.

The first bellows member 250 may be formed of a metallic bellows construction. The second bellows member 260 may be formed of rubber or rubber like material. The rubber like material may be an appropriate plastic material or a mixture of plastic material and rubber material.

The small volume changes in the second bellows chamber 270 must also be compensated. This may be done so that the second bellows member 260 is adapted to be able to expand also in the radial direction or by using a small additional pressure compensator connected to the second bellows chamber 270.

The walls 21, 22, 23 in the enclosure 20 may be formed as single walls or as double walls with an intermediate space between the outer wall and the inner wall.

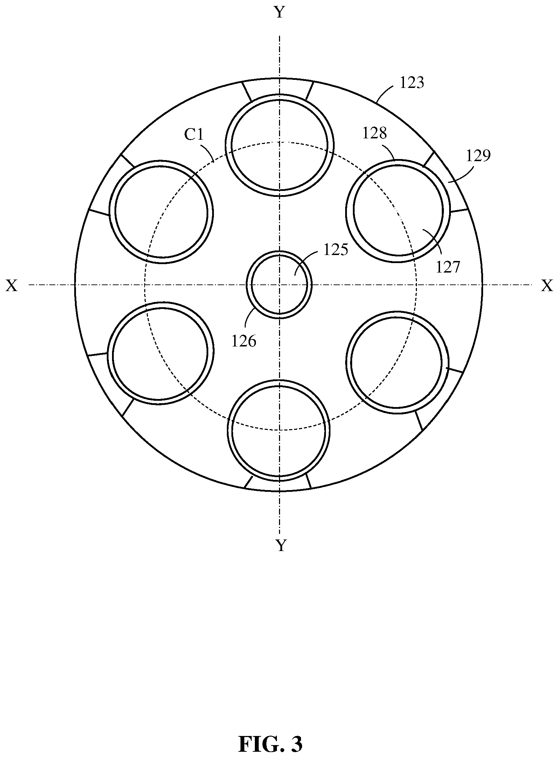

Figure 2 shows a cross-sectional side view of a cooling arrangement of the subsea installation of figure 1 and figure 3 shows a cross-section of a magnet structure.

The cooling arrangement 100 may comprises an impeller 110 arranged within the enclosure 20 i.e. within the tank 20 and a motor 130 arranged without the tank 20. The impeller 110 may be connected to the motor 130 via a contactless coupling 120, 140 based on magnets positioned on opposite sides of a wall 23 of the enclosure 20. The portion of the wall 23 of the enclosure 20 comprising the cooling arrangement 100 may be straight.

The impeller 110 may be attached to a first magnet structure 120. The first magnet structure 120 may be rotatably supported on a first shaft 125 attached to an inner surface of the wall 23 of the tank 20. The first shaft 125 may protrude perpendicularly inwards from an inner surface of the wall 23 of the tank 20. The first magnet structure 120 may comprise a frame structure 121. The frame structure 121 may comprise a first portion 122 and a second portion 123. The first portion 122 and the second portion 123 may be substantially cylindrical. A diameter of the second portion 123 may be greater than a diameter of the first portion 122. The second portion 123 may comprise a hole 126 receiving the first bearing shaft 125. The second portion 123 may further comprise permanent magnets 127 positioned within the second portion 123 and producing a magnetic field towards the wall 23 of the tank 20. The permanent magnets 127 may have a cylindrical shape and they may be positioned in blind-bored holes 128 in the second portion 123. The blind bored holes 128 may be distributed along a circle C1 having a diameter that is smaller than an outer diameter of the second portion 123. The blind bores 128 of the permanent magnets 127 may be opened 129 towards to outer perimeter of the second portion 123.

The shaft 135 of the motor 130 may be attached to a second magnet structure 140. The second magnet structure 140 may be rotatably supported on a second shaft 145 attached to an outer surface of the wall 23 of the tank 20. The second shaft 145 may protrude perpendicularly outwards from an outer surface of the wall 23 of the tank 20. The second magnet structure 140 may comprise a frame structure 141. The frame structure 141 may comprise a first portion 142 and a second portion 143. The first portion 142 and the second portion 143 may be substantially cylindrical. A diameter of the second portion 143 may be greater than a diameter of the first portion 142. The second portion 143 may comprise a hole 146 receiving the second shaft 145. The second portion 143 may further comprise permanent magnets 147 positioned within the second portion 143 and producing a magnetic field towards the wall 23 of the tank 20. The permanent magnets 147 may have a cylindrical shape and they may be positioned in blind-bored holes 148 in the second portion 143. The blind bored holes 148 may be distributed along a circle C1 having a diameter that is smaller than an outer diameter of the second portion 143. The blind bores 148 of the permanent magnets 147 may be opened 149 towards to outer perimeter of the second portion 143.

The side openings 129, 149 in the blind bores 128, 148 help in directing the magnetic fields of the permanent magnets 127, 147 at opposite sides of the wall 23 of the tank 20 towards each other in order to achieve a strong magnetic coupling between the two magnet structures 120, 140. The magnetic coupling between the two magnet structures 120, 140 results in that the impeller 110 rotates in synchronism with the shaft 135 of the motor 130.

An end of the second portion 123 of the frame structure 121 of the first magnet structure 120 may be seating against an inner surface of the wall 23 of the enclosure 20. An end of the second portion 143 of the frame structure 141 of the second magnet structure 140 may be seating against an inner surface of the wall 23 of the enclosure 20. The first shaft 125 and the second shaft 145 may be concentric i.e. they may be positioned on a common centre axis Z-Z. An outer diameter the second portion 123 of the frame structure 121 of the first magnet structure 120 may correspond to an outer diameter of the second portion 143 of the frame structure 141 of the second magnet structure 140. The respective blind bores 128, 148 in the second portions 123, 143 of the frame structures 123, 143 of the magnet structures 120, 140 may be concentric in relation to each other.

The motor 130 and the second magnet construction 140 may be positioned in a casing 150. The casing 150 may be attached to the outer surface of the wall 23 in the tank 20. The casing 150 may be provided with a second pressure compensator 160. The second pressure compensator 160 may operate according to the same principle as the first pressure compensator 200 of the tank 20. The second pressure compensator 160 may comprise a stationary bottom plate 161 and a movable top plate 162. The top plate 162 may be movably supported on guide members 163 being attached to the bottom plate 161. The top plate 162 may thus move along the guide members 163. The second pressure compensator 160 may further comprise two concentric bellows members 164, 165 extending between the bottom plate 161 and the top plate 162. A first bellows chamber 166 may be formed inside the first bellows member 164 and a second bellows chamber 167 may be formed between the two bellows members 164, 165. The second bellows chamber 167 may be filled with an intermediate fluid. The first bellows chamber 166 is connected to the interior of the casing 150. The casing 150 may be filled with a dielectric fluid 31.

The first bellows member 164 may be formed of a metallic bellows construction. The second bellows member 165 may be formed of rubber or rubber like material. The rubber like material may be an appropriate plastic material or a mixture of plastic material and rubber material.

The small volume changes in the second bellows chamber 167 must also be compensated. This may be done so that the second bellows member 165 is adapted to be able to expand also in the radial direction or by using a small additional pressure compensator connected to the second bellows chamber 167.

The first magnet structure 120 and the second magnet structure 140 may be identical.

The first magnet structure 120 and the second magnet structure 140 may comprise a horizontal centre line X-X and a vertical centre line Y-Y.

The dielectric fluid 30 which is heated by the transformer 10 will flow upwards towards the roof 22 of the tank 20 due to gravity i.e. the heated dielectric fluid is lighter than the cooled dielectric fluid. The heated dielectric fluid 30 will be cooled when reaching the roof 22 as the sea water outside the tank 20 will cool the walls 21, 22, 23 of the tank 20. The cooled dielectric fluid 30 will flow downwards towards the bottom 21 of the tank 20. This downwards flow of the cooled dielectric fluid 30 will be stronger in the peripheral portions of the tank 20 near the side wall 23 of the tank 20. This passive circulation of the dielectric fluid 30 within the tank 20 due to gravity will be intensified by the impeller 110 causing a forced circulation of the dielectric fluid 30 within the tank 20. This forced circulation of the dielectric fluid 30 within the tank 20 will contribute to the cooling of the dielectric fluid 30 within the tank 20.

The motor 130 and the second magnet structure 140 may be enclosed in a separate casing 150 being attached to the outside of the tank 20. This means that access to the motor 130 within the casing 150 is possible without opening the enclosure 20 of the electric component 10. The casing 150 may be realized as a changeable module.

The motor 130 may be an electric motor or a hydraulic motor. The supply cables to the electric motor and the hydraulic conduits to the hydraulic motor may pass through a wall on the casing 150. The supply cables and the hydraulic conduits must be sealed when passing through wall in the casing 150.

The cooling arrangement could be applied in any subsea installation comprising an electric component within an enclosure.

The casing 150 may be pressure compensated as shown in the figure, but the casing 150 could on the other hand be realized without pressure compensation. The walls of the casing 150 would then have to be dimensioned to withstand the pressures acting on the bottom of the sea.

The pressure compensation of the enclosure 20 and/or the casing 150 is not limited to the pressure compensators 200,160 shown in the figures. Any kind of pressure compensator may be used in connection with the enclosure 20 and/or in connection with the casing 150. The pressure compensator could be based on a membrane acting in an opening between the interior and the exterior of the enclosure 20 and/or the casing 150. The pressure compensator could on the other hand be based on a single or double bellows type pressure compensator or a bottle type pressure compensator.

The subsea installation is adapted to be operated in a pressurized environment i.e. in an environment having a pressure considerably higher than the normal air pressure 1 bar. The subsea installation may e.g. be positioned on the bottom of the sea. The subsea installation may be used in water depths in the range of 100 to 3000 m, whereby the prevailing pressure may be in the range of 10 to 300 bar. The water temperature in an ocean is typically 5 to 6 degrees Celsius in the depth of 1000 m and 0 to 3 degrees Celsius in the depth of 3000 m.

The current passing through the electric component in the subsea installation may be in the range of 100 to 1000 amperes (RMS). The voltage acting on the electric component in the subsea installation may be in the range of 100 to 50 000 volts (RMS).

The dielectric fluid used in the subsea installation may be a dielectric liquid e.g. a dielectric oil. The dielectric oil may be a transformer oil or an insulating oil. Transformer oil or insulating is an oil that is stable at high temperatures and has excellent electrical insulating properties. It may be used in oil-filled transformers, some types of high-voltage capacitors, fluorescent lamp ballasts, and some types of high-voltage switches and circuit breakers. The functions of transformer oil or insulation oil are to insulate, suppress corona discharge and arcing, and to serve as a coolant.

The enclosure 20 and/or the casing 150 may be filled with a dielectric fluid 30, 31. The pressure prevailing outside the enclosure 20 and/or the casing 150 will act through the respective pressure compensator 200, 160 on the pressure of the dielectric fluid 30, 31 within the enclosure 20 and/or the casing 150. The pressure of the dielectric fluid 30, 31 within the enclosure 20 and/or the casing 150 will thus follow the pressure that is prevailing outside the enclosure 20 and/or the casing 150. A close to zero differential pressure can thus be maintained between the inside and the outside of the enclosure 20 and/or the casing 150.

The figures show an embodiment in which the enclosure 20 is pressure compensated with a first pressure compensator 200. This is an advantageous embodiment. The first pressure compensator 200 might, however, not be needed in all circumstances. It might be possible, in some circumstances, to leave the first pressure compensator 200 out and to have a strong enclosure 20 withstanding the pressure from the sea water outside the enclosure 20.

The figures show an embodiment in which the casing 150 is pressure compensated with a second pressure compensator 160. This is an advantageous embodiment. The second pressure compensator 160 might, however, not be needed in all circumstances. It might be possible, in some circumstances, to leave the second pressure compensator out and to have a strong casing 150 withstanding the pressure from the sea water outside the casing 150.

The invention can be used in all subsea installations with liquid cooling in a closed container or tank, the liquid being circulated with a pump in order to enforce the natural convection within the container.

It will be obvious to a person skilled in the art that, as the technology advances, the inventive concept can be implemented in various ways. The invention and its embodiments are not limited to the examples described above but may vary within the scope of the claims.

## Claims

1. A subsea installation comprising
an enclosure (20) filled with a dielectric fluid (30),
an electric component (10) being positioned within the enclosure (20),
a cooling arrangement (100) for intensifying the cooling of the dielectric fluid (30) within the enclosure (20),
**characterized in that**
the cooling arrangement (100) comprises an impeller (110) fitted within the enclosure (20) and a motor (130) fitted outside the enclosure (20), the impeller (110) being connected to the motor (130) via a contactless coupling (120, 140) based on magnets positioned on opposite sides of a wall (23) of the enclosure (20), whereby the wall (23) of the enclosure (20) remains unbroken.

2. The subsea installation as claimed in claim 1, wherein the enclosure (20) is pressure compensated with a first pressure compensator (200).

3. The subsea installation as claimed in claim 1 or 2, wherein the electric component (10) is a transformer.

4. The subsea installation as claimed in claim 3, wherein the enclosure (20) is a tank.

5. The subsea installation as claimed in any one of claims 1 to 4, wherein the motor (130) is fitted in a casing (150) attached to an outer surface of the enclosure (20).

6. The subsea installation as claimed in claim 5, wherein the casing (150) is pressure compensated with a second pressure compensator (160).

7. The subsea installation as claimed in any one of claims 1 to 6, wherein the contactless coupling (120, 140) between the impeller (110) and the motor (130) is formed of a first magnet structure (120) connected to the impeller (110) and positioned within the enclosure (20) and a second magnet structure (140) connected to the motor (130) and positioned outside the enclosure (20), the first magnet structure (120) and the second magnet structure (140) being provided with permanent magnets (128, 148).

8. The subsea installation as claimed in claim 7, wherein the first magnet structure (120) comprises a frame structure (121) being rotatably supported on a first shaft (125) attached to an inner surface of the enclosure (20) and the second magnet structure (140) comprises a frame structure (141) being rotatably supported on a second shaft (145) attached to an outer surface of the enclosure (20).

9. The subsea installation as claimed in claim 8, wherein the first frame structure (121) and the second frame structure (141) are substantially cylindrical so that end surfaces of the cylinders are positioned against the wall (23) of the enclosure (20), the cylinders being concentric.

10. The subsea installation as claimed in claim 9, wherein the frame structure (121) in the first magnet structure (120) and the frame structure (121) in the second magnet structure (140) comprises blind bored holes (128, 148) distributed along a circle (C1) for receiving the permanent magnets (127, 147), whereby the permanent magnets (127, 147) in each frame structure (121, 141) are positioned concentric in relation to each other on opposite sides of the wall (23) of the enclosure (20).

11. The subsea installation as claimed in any one of claims 1 to 10, wherein the motor (130) is an electric motor.
